# EUROPÄISCHE PATENTSCHRIFT

(11) **EP 3 197 704 B1**
(45) Veröffentlichungstag und Bekanntmachung des Hinweises auf die Patenterteilung: **24.03.2021**
(21) Anmeldenummer: 15770832.2
(22) Anmeldetag: 14.09.2015
(51) Int. Cl.: B60L 3/04, B60L 3/00, B60L 50/40, B60L 50/52, B60L 53/16

(54) **SCHALTUNGSVORRICHTUNG UND VERFAHREN ZUM ERMITTELN EINES ZUSTANDES EINER VERRIEGELUNGSLEITERSCHLEIFE**
CIRCUIT DEVICE AND METHOD FOR ASCERTAINING A STATE OF A LOCKING CONDUCTOR LOOP
SYSTÈME DE CIRCUIT ET PROCÉDÉ PERMETTANT DE DÉTERMINER UN ÉTAT D'UNE BOUCLE CONDUCTRICE DE VERROUILLAGE

(30) Priorität: 24.09.2014 DE 102014219235
(43) Veröffentlichungstag der Anmeldung: 02.08.2017
(73) Patentinhaber: Vitesco Technologies Germany GmbH, 30165 Hannover (DE)
(72) Erfinder: FOUEDJIO, Pulcherie Ide, 90427 Nürnberg (DE); WINKLER, Karl-Heinz, 90518 Altdorf (DE)
(74) Vertreter: Waldmann, Georg Alexander
(86) Internationale Anmeldenummer: PCT/EP2015/070922
(87) Internationale Veröffentlichungsnummer: WO 2016/045998

(56) Entgegenhaltungen:
- WO-A2-2009/112165
- DE-A1-102012 105 631
- US-A1- 2013 187 634

## Beschreibung

Die vorliegende Erfindung betrifft eine Schaltungsvorrichtung zum Ermitteln eines Zustandes einer Verriegelungsleiterschleife, wobei die Verriegelungsleiterschleife ihrerseits zur Überwachung einer Hochvoltkomponente eingerichtet ist. Ferner betrifft die Erfindung eine Berührungsschutzschaltung mit einer genannten Schaltungsvorrichtung und einer genannten Verriegelungsleiterschleife, sowie ein Fahrzeug mit einer genannten Berührungsschutzschaltung. Außerdem betriff die Erfindung ein Verfahren zum Ermitteln des Zustandes der genannten Verriegelungsleiterschleife.

Moderne Fahrzeuge, insb. Hybridelektro- oder Elektrofahrzeuge, umfassen Hochvoltbordnetzzweige bzw. Hochvoltkomponenten, wie z. B. Traktionsbatterien, elektrische Maschinen, Leistungselektroniken und/oder Superkondensatoren, deren Betriebsspannungen weit über 60 Volt und sogar über 450 Volt liegen. Spannungen von über 60 Volt sind für Menschen und Tiere lebensgefährlich. Deshalb sind die Hochvoltkomponenten mit verschiedenen Berührungsschutzelementen ausgestattet, bei deren Aktivierung mögliche Gefahren für Menschen und Tiere signalisiert werden, die aus den Hochvoltkomponenten ausgehen. Dabei sind die Berührungsschutzelemente beispielsweise als Verriegelungselemente an den Steckkontakten oder Steckverbindungen der Hochvoltkomponenten oder deren Gehäusen ausgebildet. Werden die Steckkontakte oder Steckverbindungen der Hochvoltkomponenten getrennt oder die Gehäuse der Hochvoltkomponenten geöffnet, so werden die Berührungsschutzelemente aktiviert.

Außerdem sind die modernen Fahrzeuge mit Berührungsschutzschaltungen ausgestattet, die elektrische Verriegelungsleiterschleifen (in Englisch "Interlock-Loop" oder "Interlock-Loop-Circuit") umfassen. Mit den Verriegelungsleiterschleifen überwachen die Berührungsschutzschaltungen die Berührungsschutzelemente. Werden die Berührungsschutzelemente in zuvor genannter Weise aktiviert, so werden die Verriegelungsleiterschleifen elektrisch unterbrochen. Werden derartige Unterbrechungen der Verriegelungsleiterschleifen von den entsprechenden Berührungsschutzschaltungen erfasst, so senden diese bspw. entsprechende Steuersignale an die betroffenen Hochvoltkomponenten und deaktivieren diese. Die Deaktivierung der Hochvoltkomponenten geschieht beispielsweise durch elektrisches Trennen der Hochvoltkomponenten von dem Hochvoltbordnetzzweig bzw. von dem Bordnetz, durch Abschalten oder durch Entladen der Hochvoltkomponenten, wie der Superkondensatoren.

Eine Patentoffenlegungsschrift WO 2009/112165 A2 beschreibt eine Überwachungsvorrichtung zum Berührungs- oder Zugangsschutz eines Hybridfahrzeugs mit einer Anzahl von Hochvoltkomponenten mit einer an eine Niedervolt-Bordnetzbatterie angeschlossenen elektronischen Steuerungseinheit, deren Leistungstellglieder über einen Leistungsschalter an eine Hochvoltbatterie angeschlossen sind und mindestens eine elektrische Maschine ansteuern. Die Hochvoltkomponenten werden mittels einer Leitungsschleife überwacht und bei geöffneter Leitungsschleife deaktiviert.

Eine weitere Patentoffenlegungsschrift DE 10 2012 105631 A1 beschreibt eine Hochvolt-Sicherheitsverriegelung für HV-Komponenten in einem Fahrzeug mit einem HV-Stecker. Im HV-Stecker ist eine Sicherheitsbrücke angeordnet.

Eine weitere Patentoffenlegungsschrift US2013/187634 A1 beschreibt eine Überwachungseinrichtung, welche einen ersten Leitungsabschnitt mit einer ersten Anschlussstelle und einer von der ersten Anschlussstelle in Leitungsrichtung beabstandeten zweiten Anschlussstelle, und eine Steuerungseinheit und mit einer ersten Stromermittlungseinheit umfasst.

Treten Fehler in den Berührungsschutzschaltungen, insbesondre in den Verriegelungsleiterschleifen, ein, so kann es vorkommen, dass die Hochvoltkomponenten in nicht gefährlichen Situationen fälschlicherweise deaktiviert werden oder umgekehrt in gefährlichen Situationen nicht zuverlässig deaktiviert werden und somit zur Gefahrenquelle für die Menschen und Tiere werden.

Damit besteht die Aufgabe der vorliegenden Erfindung darin, einen zuverlässigen Schutz der Menschen und Tiere vor den Gefahren durch die Hochvoltkomponenten, insb. eines Fahrzeugs, zu ermöglichen.

Diese Aufgabe wird durch Gegenstände der unabhängigen Ansprüche gelöst. Vorteilhafte Ausgestaltungen sind Gegenstand der Unteransprüche.

Gemäß einem ersten Aspekt der Erfindung wird eine Schaltungsvorrichtung zum Ermitteln eines Zustandes einer elektrischen Verriegelungsleiterschleife, insb. einer Berührungsschutzschaltung eines Fahrzeugs, speziell eines Hybridelektro-/Elektrofahrzeugs, bereitgestellt, wobei die Verriegelungsleiterschleife ihrerseits zur Überwachung zumindest einer Hochvoltkomponente insb. des Fahrzeugs, speziell des Hybridelektro-/Elektrofahrzeugs, eingerichtet ist.

Die Schaltungsvorrichtung umfasst einen Stromanschluss, über den die Schaltungsvorrichtung mit einer Spannungsquelle bzw. einem positiven Stromanschluss der Spannungsquelle elektrisch verbunden wird.

Ferner umfasst die Schaltungsvorrichtung einen Masseanschluss, über den die Schaltungsvorrichtung mit elektrischer Masse elektrisch verbunden wird.

Außerdem umfasst die Schaltungsvorrichtung einen positiven Anschluss und einen negativen Anschluss. Über den positiven Anschluss wird die Schaltungsvorrichtung mit einem Leitungsende der Verriegelungsleiterschleife und über den negativen Anschluss mit einem weiteren Leitungsende der Verriegelungsleiterschleife elektrisch verbunden.

Die Schaltungsvorrichtung umfasst ferner eine Messanordnung, die eingerichtet ist, an dem negativen Anschluss ein erstes Spannungspotential (also als ein erstes Potentialmesswert) zu messen, wenn ein erster Strom (einschließlich einem Strom mit einer Stromstärke von 0 Ampere) von dem Stromanschluss über den negativen Anschluss zu dem Masseanschluss fließt. Die Messanordnung ist ferner eingerichtet, an dem negativen Anschluss ein zweites Spannungspotential (also als ein zweites Potentialmesswert) zu messen, wenn ein zweiter, von dem ersten Strom (durch bspw. eine andere Stromstärke oder eine entgegengesetzte Stromflussrichtung) abweichender Strom (einschließlich einem Strom mit einer Stromstärke von 0 Ampere) von dem Stromanschluss über den negativen Anschluss zu dem Masseanschluss fließt. Hierzu weist die Messanordnung einen Signaleingang auf, über den die Messanordnung mit dem negativen Anschluss elektrisch verbunden ist und das Spannungspotential an dem negativen Anschluss misst.

Die Schaltungsvorrichtung umfasst zudem eine Ermittlungsanordnung, die signaleingangsseitig mit dem Signalausgang der Messanordnung elektrisch verbunden ist. Die Ermittlungsanordnung umfasst eine Vergleichseinheit, die eingerichtet ist, den ersten, von der Messanordnung weitergeleiteten Potentialmesswert mit einem ersten und einem zweiten Potentialreferenzwert zu vergleichen und den zweiten, von der Messanordnung weitergeleiteten Potentialmesswert mit einem dritten und einem vierten Potentialreferenzwert zu vergleichen. Die Ermittlungsanordnung ist ferner eingerichtet, basierend auf den Vergleichsergebnissen der Vergleichseinheit zu ermitteln, ob der negative Anschluss mit dem positiven Anschluss, dem Stromanschluss oder dem Masseanschluss, oder mit keinem von den drei Anschlüssen (also dem positiven Anschluss, dem Stromanschluss bzw. dem Masseanschluss) elektrisch kurzgeschlossen ist.

Die Schaltungsvorrichtung kann vorzugsweise auf einem Schaltungsträger ausgebildet sein, wobei die Ermittlungsanordnung bspw. als ein Mikroprozessor ausgebildet sein kann. Alternativ kann die Schaltungsvorrichtung dezentral auf mehreren Schaltungsträgern verteilt ausgebildet sein.

Der Erfindung liegt die Erkenntnis zugrunde, dass es verschiedene mögliche Fehlerquellen gibt, die die Verriegelungsleiterschleife in die verschiedenen fehlerhaften Zustände überführen. Unter den möglichen fehlerhaften Zuständen sind die folgenden drei Fehlerzustände besonders relevant für die Funktionalität der Verriegelungsleiterschleife bzw. besonders gefährlich für die Menschen und die Tiere und müssen somit von den restlichen fehlerhaften Zuständen der Verriegelungsleiterschleife eindeutig getrennt und gesondert behandelt werden. Diese Zustände sind:
- eine elektrische Unterbrechung in der Verriegelungsleiterschleife;
- ein elektrischer Kurzschluss der Verriegelungsleiterschleife mit der Spannungsquelle;
- ein elektrischer Kurzschluss der Verriegelungsleiterschleife mit der elektrischen Masse.

Basierend auf dieser Erkenntnis wurde im Rahmen dieser Erfindung nach einer Lösung gesucht, mit der diese drei Fehlerzustände voneinander und von den restlichen fehlerhaften Zuständen eindeutig und zuverlässig ermittelt werden können.

Als die Lösung wurde somit eine Schaltungsvorrichtung mit einer Messanordnung bereitgestellt, mit der ein Spannungspotential an einem Leitungsende der Verriegelungsleiterschleife gemessen werden kann, das mit einem negativen Anschluss der Schaltungsvorrichtung elektrisch verbunden ist. Das Spannungspotential an diesem Leitungsende stellt eine Spannung dar, die zwischen dem genannten Leistungsende der Verriegelungsleiterschleife und der elektrischen Masse abfällt. Dabei ändert sich diese Spannung abhängig von dem Zustand der Verriegelungsleiterschleife, insb. den drei zuvor genannten relevanten Fehlerzuständen der Verriegelungsleiterschleife.

Im Rahmen der Erfindung wurde aber festgestellt, dass auch die zuvor genannten restlichen fehlerhaften Zustände in der Verriegelungsleiterschleife zu Änderungen der oben genannten Spannung führen. Zudem wurde festgestellt, dass auch in der Schaltungsvorrichtung selbst Fehler eintreten können, die zu Änderungen der genannten Spannung führen.

Um die drei relevanten Fehlerzustände dennoch voneinander und von den restlichen fehlerhaften Zuständen in der Verriegelungsleiterschleife und den Fehlern in der Schaltungsvorrichtung eindeutig und zuverlässig trennen zu können, wurde im Rahmen der Erfindung vorgesehen, zumindest zwei Messungen der genannten Spannung bei unterschiedlichen elektrischen Strömen durchzuführen, wobei diese Ströme voneinander durch ihre Stromstärken oder Stromflussrichtungen unterscheiden. Durch die Mehrfachmessungen (zumindest zwei Messungen) werden zumindest zwei Potentialmesswerte der genannten Spannung bzw. des entsprechenden Spannungspotentials gewonnen, die dann von einer nachgeschalteten Ermittlungsanordnung jeweils mit zumindest zwei im Vorfeld ermittelten Potentialreferenzwerten verglichen werden. Die Vergleichsergebnisse werden dann von der Ermittlungsanordnung miteinander logisch verknüpft und mit vorab ermittelten logischen (Referenz-)Verknüpfungen verglichen, die jeweils den jeweiligen zuvor beschriebenen drei Fehlerzuständen, einem fehlerfreien Zustand der Verriegelungsleiterschleife sowie den nicht relevanten restlichen Fehlerzuständen zugeordnet sind.

Basierend auf dem Vergleichsergebnis der logischen Verknüpfungen kann dann der aktuelle Zustand der Verriegelungsleiterschleife, insb. im Hinblick auf die drei relevanten Fehlerzustände, eindeutig und zuverlässig ermittelt werden.

Damit ist eine Möglichkeit bereitgestellt, mit der die Hochvoltkomponenten, insb. eine Traktionsbatterie, eine Leistungselektronik, eine elektrische Maschine, ein Superkondensator (so genannten "Super-Cap") eines Fahrzeugs, speziell eines Hybridelektro- oder Elektrofahrzeugs, sicher überwacht werden können und somit die Menschen und Tiere vor Gefahren durch die Hochvoltkomponenten zuverlässig geschützt werden können.

Vorzugsweise umfasst die Schaltungsvorrichtung ferner eine steuerbare, insb. gesteuert ein-/ausschaltbare, Stromquelle, die zwischen dem negativen Anschluss und dem Masseanschluss angeschlossen und eingerichtet ist, die beiden zuvor genannten Ströme (einschließlich den Strömen mit Stromstärken von 0 Ampere) bereitzustellen.

Dabei ist die Stromquelle vorzugsweise als eine Konstantstromquelle oder als eine skalierbare bzw. modulierbare Stromquelle ausgebildet.

Die Stromquelle umfasst vorzugsweise eine Stromspiegelschaltung, die eingerichtet ist, lastunabhängige Ströme bereitzustellen, die unabhängig von den Spannungsschwankungen in der Betriebsspannung der Spannungsquelle konstant bleiben.

Die Schaltungsvorrichtung umfasst vorzugsweise eine Strombegrenzungsschaltung, die zwischen dem Stromanschluss und dem positiven Anschluss sowie zwischen dem Stromanschluss und dem negativen Anschluss bzw. der Messanordnung elektrisch angeschlossen ist. Die Strombegrenzungsschaltung dient zur Begrenzung der durch die Verriegelungsleiterschleife bzw. die Schaltungsvorrichtung fließenden Ströme und somit zum Schutz der Schaltungsvorrichtung vor einer Überspannung oder einem Überstrom.

Vorzugsweise umfasst die Schaltungsvorrichtung ferner einen Überbrückungswiderstand, der zwischen dem Stromanschluss und dem negativen Anschluss bzw. zwischen dem positiven und dem negativen Anschluss elektrisch angeschlossen ist. Der Überbrückungswiderstand dient zum Überbrücken der Verriegelungsleiterschleife, wenn diese und somit die elektrische Verbindung zwischen dem positiven und dem negativen Anschluss unterbrochen ist.

Die Messanordnung umfasst vorzugsweise eine Schutzschaltungseinheit, die zwischen dem Signalausgang der Messanordnung und dem Signaleingang der Ermittlungsanordnung angeschlossen ist und eingerichtet ist, die Ermittlungsanordnung vor einer Über- und/oder Unterspannung zu schützen.

Gemäß einem weiteren Aspekt der Erfindung wird eine Berührungsschutzschaltung zur Überwachung zumindest einer Hochvoltkomponente, insb. eines Fahrzeugs, speziell eines Hybridelektro- oder Elektrofahrzeugs, bereitgestellt. Dabei umfasst die Berührungsschutzschaltung eine elektrische Verriegelungsleiterschleife zur Überwachung der zumindest einen Hochvoltkomponente und eine zuvor beschriebene Schaltungsvorrichtung zum Ermitteln des Zustandes der Verriegelungsleiterschleife. Dabei ist die Schaltungsvorrichtung über den positiven Anschluss mit einem elektrischen Leitungsende der Verriegelungsleiterschleife und über den negativen Anschluss mit einem weiteren elektrischen Leitungsende der Verriegelungsleiterschleife elektrisch verbunden.

Gemäß noch einem weiteren Aspekt der Erfindung wird ein Fahrzeug, insb. ein Hybridelektro- oder Elektrofahrzeug, bereitgestellt, das zumindest eine Hochvoltkomponente, insb. eine Traktionsbatterie, eine Leistungselektronik, eine elektrische Maschine und/oder einen Superkondensator, sowie zumindest eine zuvor beschriebene Berührungsschutzschaltung zur Überwachung der zumindest einen Hochvoltkomponente umfasst.

Gemäß noch einem weiteren Aspekt der Erfindung wird ein Verfahren zum Ermitteln eines Zustandes einer zuvor beschriebenen elektrischen Verriegelungsleiterschleife mit einer oben beschriebenen Schaltungsvorrichtung bereitgestellt.

Gemäß dem Verfahren wird ein erster Strom (einschließlich einem Strom mit einer Stromstärke von 0 Ampere) generiert, der von dem Stromanschluss der Schaltungsvorrichtung über den negativen Anschluss zu dem Masseanschluss der Schaltungsvorrichtung fließt. Während der erste Strom fließt (bzw. auch kein Strom fließt), wird an dem negativen Anschluss der Schaltungsvorrichtung das Spannungspotential als ein erster Potentialmesswert gemessen. Der erste Potentialmesswert wird anschließend mit einem ersten Potentialreferenzwert und einem zweiten Potentialreferenzwert verglichen, wobei der zweite Potentialreferenzwert größer als der erste Potentialreferenzwert ist.

Es wird ferner ein zweiter, von dem ersten Strom (durch bspw. eine andere Stromstärke oder eine entgegengesetzte Stromflussrichtung) abweichender Strom (einschließlich einem Strom mit einer Stromstärke von 0 Ampere) generiert, der ebenfalls von dem Stromanschluss der Schaltungsvorrichtung über den negativen Anschluss zu dem Masseanschluss der Schaltungsvorrichtung fließt. Während der zweite Strom fließt (bzw. auch kein Strom fließt), wird an dem negativen Anschluss der Schaltungsvorrichtung das Spannungspotential als ein zweiter Potentialmesswert gemessen. Der zweite Potentialmesswert wird anschließend mit einem dritten Potentialreferenzwert und einem vierten Potentialreferenzwert verglichen, wobei der vierte Potentialreferenzwert größer als der dritte Potentialreferenzwert ist.

Ein fehlerfreier geschlossener und somit elektrisch leitender Zustand der Verriegelungsleiterschleife wird erkannt, falls der erste Potentialmesswert zwischen dem ersten und dem zweiten Potentialreferenzwert liegt und zugleich der zweite Potentialmesswert größer als der vierte Potentialreferenzwert ist.

Sofern die beiden oben genannten logischen Verknüpfungen zwischen den beiden gemessenen Potentialmesswerten und den vier Potentialreferenzwerten nicht zeitgleich vorliegen, wird von einem fehlerhaften Zustand der Verriegelungsleiterschleife ausgegangen.

Vorzugsweise wird eine elektrische Unterbrechung der Verriegelungsleiterschleife erkannt, falls der erste Potentialmesswert kleiner als der erste Potentialreferenzwert ist und zugleich der zweite Potentialmesswert größer als der vierte Potentialreferenzwert ist.

Ferner wird vorzugsweise ein elektrischer Kurzschluss der Verriegelungsleiterschleife bzw. des negativen Anschlusses der Schaltungsvorrichtung zu dem Stromanschluss der Schaltungsvorrichtung bzw. zu dem positiven Stromanschluss der Spannungsquelle erkannt, falls der erste Potentialmesswert größer als der zweite Potentialreferenzwert ist und zugleich der zweite Potentialmesswert größer als der vierte Potentialreferenzwert ist.

Analog wird vorzugsweise ein elektrischer Kurzschluss der Verriegelungsleiterschleife zu dem Masseanschluss bzw. zu der elektrischen Masse erkannt, falls der erste Potentialmesswert kleiner als der erste Potentialreferenzwert ist und zugleich der zweite Potentialmesswert kleiner als der dritte Potentialreferenzwert ist.

Liegt keiner der oben genannten logischen Verknüpfungen vor, so wird von einem weiteren, nicht eindeutig zuordenbaren fehlerhaften Zustand der Verriegelungsleiterschleife bzw. der Schaltungsvorrichtung ausgegangen.

Vorteilhafte Ausgestaltungen der oben beschriebenen Schaltungsvorrichtung sind, soweit im Übrigen auf die oben genannte Berührungsschaltung oder auf das oben genannte Fahrzeug bzw. auf das oben genannte Verfahren übertragbar, auch als vorteilhafte Ausgestaltungen der Berührungsschutzschaltung, des Fahrzeugs bzw. des Verfahrens anzusehen.

Analog sind vorteilhafte Ausgestaltungen des oben beschriebenen Verfahrens, soweit im Übrigen auf die oben beschriebene Schaltungsvorrichtung, auf die oben genannte Berührungsschaltung oder auf das oben genannte Fahrzeug übertragbar, auch als vorteilhafte Ausgestaltungen der Schaltungsvorrichtung, der Berührungsschutzschaltung bzw. des Fahrzeugs anzusehen.

Im Folgenden werden beispielhafte Ausführungsformen der Erfindung Bezug nehmend auf beiliegenden Zeichnungen näher erläutert. Dabei zeigen:
- Figur 1: in einer schematischen Schaltungstopologie eine Berührungsschutzschaltung mit einer Schaltungsvorrichtung gemäß einer Ausführungsform der Erfindung;
- Figur 2: in einem Ablaufdiagramm ein Verfahren zum Ermitteln eines Zustandes einer elektrischen Verriegelungsleiterschleife mit der Schaltungsvorrichtung gemäß einer weiteren Ausführungsform der Erfindung.

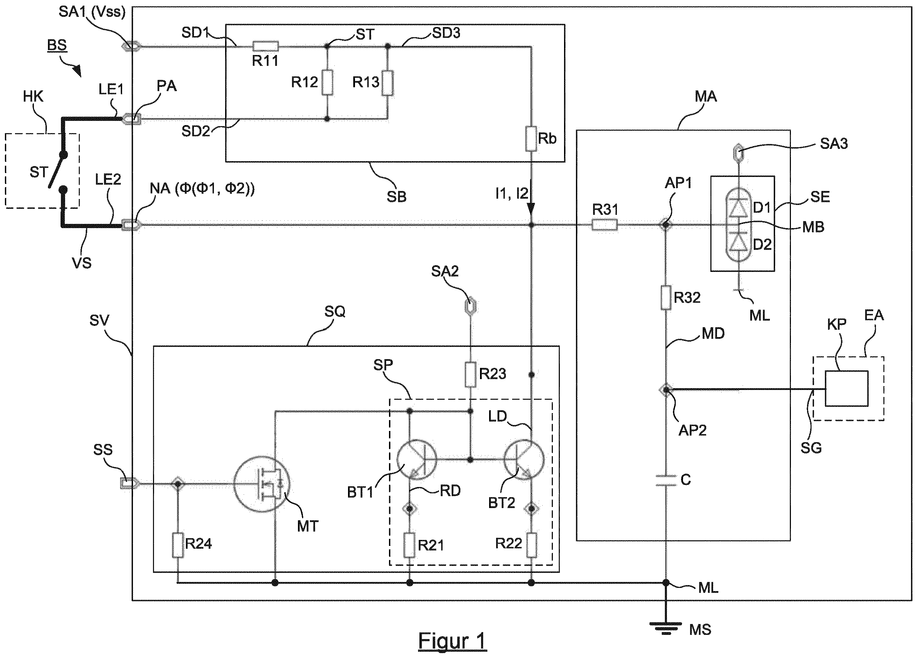

Figur 1 zeigt eine Berührungsschutzschaltung BS eines in der Figur nicht dargestellten Elektrofahrzeugs für eine oder mehrere Hochvoltkomponenten HK des Elektrofahrzeugs, die beispielsweise eine Traktionsbatterie, eine elektrische Maschine, einen Superkondensator sowie Leistungselektronikschaltungen umfassen.

Betriebsspannungen dieser Hochvoltkomponenten HK liegen weit über 60 Volt und somit sind für Menschen und Tiere lebensgefährlich. Zum Schutz von Menschen und Tieren vor lebensgefährlichen Stromschlägen werden die Hochvoltkomponenten HK durch entsprechende Gehäuse oder sonstige Isoliermaßnahmen von der Umgebung elektrisch isoliert. Sind ein oder mehrere Gehäuse oder eine oder mehrere Isoliermaßnahmen der Hochvoltkomponenten HK beispielweise durch eine externe mechanische Einwirkung beschädigt oder unbeabsichtigt geöffnet bzw. deaktiviert, so droht für die Menschen und Tiere eine Lebensgefahr durch einen Stromschlag.

Um dies entgegenzuwirken, umfasst die Berührungsschutzschaltung BS eine Verriegelungsleiterschleife VS zur Überwachung der Hochvoltkomponenten HK bzw. deren Gehäuse oder deren sonstigen Isoliermaßnahmen.

Die Verriegelungsleiterschleife VS ist als eine elektrische Leitung mit einem ersten Leitungsende LE1 und einem zweiten Leitungsende LE2 ausgebildet und umfasst einen oder mehrere steuerbare Schalter ST, die abhängig von den Zuständen der der Hochvoltkomponenten HK bzw. deren Gehäuse oder deren sonstigen Isoliermaßnahmen in einer nachfolgend zu beschreibenden Weise geschlossen oder geöffnet werden können. Sind alle Schalter ST fehlerfrei geschlossen, so ist die Verriegelungsleiterschleife VS "geschlossen", wobei die beiden Leitungsende LE1, LE2 miteinander elektrisch kurzgeschlossen werden. Wird aber zumindest ein Schalter ST geöffnet, so wird die Verriegelungsleiterschleife VS unterbrochen und die beiden Leitungsende LE1, LE2 werden voneinander elektrisch "getrennt".

Die Berührungsschutzschaltung BS umfasst ferner eine Schaltungsvorrichtung SV, mit der die Berührungsschutzschaltung BS den Zustand der Verriegelungsleiterschleife VS ermittelt und abhängig von dem Zustand der Verriegelungsleiterschleife VS potentielle Gefahren erkennt.

Die Schaltungsvorrichtung SV weist einen positiven Anschluss PA und einen negativen Anschluss NA auf. Über den positiven Anschluss PA ist die Schaltungsvorrichtung SV mit dem ersten Leitungsende LE1 der Verriegelungsleiterschleife VS elektrisch verbunden. Über den negativen Anschluss NA ist die Schaltungsvorrichtung SV mit dem zweiten Leitungsende LE2 der Verriegelungsleiterschleife VS elektrisch verbunden.

Die Schaltungsvorrichtung SV weist ferner einen ersten Stromanschluss SA1 auf, über den die Schaltungsvorrichtung SV an einer externen, in der Figur nicht dargestellten Gleichspannungsquelle eines Niederspannungsbordnetzzweigs des Elektrofahrzeugs elektrisch angeschlossen ist. Die Gleichspannungsquelle stellt der Schaltungsvorrichtung SV eine Betriebsspannung Vss, die weit unter 60 Volt liegt.

Die Schaltungsvorrichtung SV weist außerdem einen zweiten Stromanschluss SA2 und einen dritten Stromanschluss SA3 auf, deren Funktionsweisen nachfolgend beschrieben werden.

Die Schaltungsvorrichtung SV weist zudem einen Masseanschluss ML auf, über den die Schaltungsvorrichtung SV an elektrischer Masse MS (Karosserie des Elektrofahrzeugs) elektrisch angeschlossen ist.

Die Schaltungsvorrichtung SV umfasst ferner eine Strombegrenzungsschaltung SB, die zwischen dem ersten Stromanschluss SA1 und dem positiven Anschluss PA bzw. zwischen dem ersten Stromanschluss SA1 und dem negativen Anschluss NA elektrisch angeschlossen ist. Dabei ist die Strombegrenzungsschaltung SB in Form von einer Sternschaltung mit einem Sternpunkt ST ausgebildet und umfasst einen ersten Strompfad SD1 zwischen dem ersten Stromanschluss SA1 und dem Sternpunkt ST, einen zweiten Strompfad SD2 zwischen dem positiven Anschluss PA und dem Sternpunkt ST sowie einen dritten Strompfad SD3 zwischen dem Sternpunkt ST und dem negativen Anschluss NA.

In dem ersten Strompfad SD1 weist die Strombegrenzungsschaltung SB einen ersten Widerstand R11 auf. In dem zweiten Strompfad SD2 weist die Strombegrenzungsschaltung SB einen zweiten und einen dritten Widerstand R12, R13 auf, die parallel zueinander geschaltet sind. In dem dritten Strompfad SD3 weist die Strombegrenzungsschaltung SB einen Überbrückungswiderstand Rb auf. Der Überbrückungswiderstand Rb kann auch in dem ersten Strompfad SD1 angeordnet sein. Analog kann die Strombegrenzungsschaltung SB je nach Ausführungen mehr oder wenige Widerstände umfassen.

Die Schaltungsvorrichtung SV umfasst außerdem eine Stromquelle SQ, die zwischen dem negativen Anschluss NA und dem Masseanschluss ML bzw. zwischen dem Überbrückungswiderstand Rb und dem Masseanschluss ML elektrisch angeschlossen ist.

Die Stromquelle SQ ist als eine gesteuert schaltbare Stromquelle ausgebildet und kann Ströme von zumindest zwei unterschiedlichen Stromwerten, wie z. B. 0 oder 10 Milliampere, erzeugen. Hierzu umfasst die Stromquelle SQ eine Stromspiegelschaltung SP und einen selbstsperrenden n-Kanal MOSFET MT zur Bereitstellung von Konstantströmen, die lastunabhängig bzw. unabhängig von der am ersten Stromanschluss SA1 anliegenden Betriebsspannung Vss generiert werden können und von den Spannungsschwankungen der Betriebsspannung Vss nicht beeinflusst werden.

Die Stromspiegelschaltung SP umfasst ihrerseits einen Referenzstrompfad RD und einen Laststrompfad LD, wobei diese beiden Strompfade RD, LD zueinander weitgehend spiegelsymmetrisch ausgebildet sind.

Der Referenzstrompfad RD umfasst einen Bipolartransistor BT1 und einen Widerstand R21, die in Reihe geschaltet sind. Analog umfasst der Laststrompfad LD einen weiteren Bipolartransistor BT2 und einen weiteren Widerstand R22, die in Reihe geschaltet sind. Dabei sind die beiden Bipolartransistoren BT1, BT2 aus gleicher Bauart und gleich dimensioniert. Die beiden Widerstände R21, R22 sind dem Stromverstärkungsfaktor der Stromspiegelschaltung SP entsprechend dimensioniert.

Die Basisanschlüsse der beiden Bipolartransistoren BT1, BT2 sind miteinander und mit dem Kollektoranschluss des referenzstrompfadseitigen Bipolartransistors BT1 sowie über einen weiteren Widerstand R23 mit dem zuvor genannten, zweiten Stromanschluss SA2 der Schaltungsvorrichtung SV elektrisch verbunden.

Über den zweiten Stromanschluss SA2 wird der Stromspiegelschaltung SP eine konstante Gleichspannung angelegt, die weit unter 60 Volt liegt.

Der Laststrompfad LD positivspannungsseitig an dem negativen Anschluss NA elektrisch angeschlossen.

Negativspannungsseitig sind der Laststrompfad LD und der Referenzstrompfad RD miteinander und mit dem Masseanschluss ML und somit mit der elektrischen Masse MS elektrisch verbunden.

Der Referenzstrompfad RD ist positivspannungsseitig bzw. über den Kollektoranschluss mit dem Drainanschluss des zuvor genannten n-Kanal MOSFETs MT elektrisch verbunden.

Der n-Kanal MOSFET MT ist somit über den Drainanschluss mit dem Kollektoranschluss des referenzstrompfadseitigen Bipolartransistors BT1 und mit den Basisanschlüssen der beiden Bipolartransistoren BT1, BT2 elektrisch verbunden.

Der MOSFET MT ist über den Sourceanschluss mit dem Masseanschluss ML und somit mit der elektrischen Masse MS elektrisch verbunden.

Über den Gateanschluss ist der MOSFET MT ist mit einem Signalanschluss SS elektrisch verbunden, über den ein Steuersignal zum Schalten des MOSFETs MT an dem Gateanschluss angelegt wird. Ferner ist der Gateanschluss über einen Pull-Down Widerstand R24 an dem Masseanschluss ML elektrisch angeschlossen.

Die Schaltungsvorrichtung SV umfasst zudem eine Messanordnung MA, die ebenfalls zwischen dem negativen Anschluss NA und dem Masseanschluss ML elektrisch angeschlossen ist.

Die Messanordnung MA umfasst einen Messpfad MD, der sich zwischen dem negativen Anschluss NA der Schaltungsvorrichtung SV und dem Masseanschluss ML erstreckt und einen ersten Widerstand R31, einen zweiten Widerstand R32 sowie einen Kondensator C umfasst, die zwischen dem negativen Anschluss NA und dem Masseanschluss ML in Reihe geschaltet sind. Dabei dienen die beiden Widerstände R31, R32 zur Stabilisierung der Spannungspotentiale Φ, die von der Messanordnung MA in einer nachfolgend zu beschreibenden Weise gemessen werden. Der Kondensator C kompensiert die Spannungsschwankungen in dem Messpfad MD.

Die Messanordnung MA umfasst eine Schutzschaltungseinheit SE, die ihrerseits zwei Dioden D1, D2 umfasst, welche zwischen dem zuvor genannten, dritten Stromanschluss SA3 der Schaltungsvorrichtung SV und dem Masseanschluss ML in Reihe und in ihrer jeweiligen Durchlassrichtung dem dritten Stromanschluss SA3 weisend geschaltet sind.

Die Schutzschaltungseinheit SE ist über einen Mittelabgriff MB, der die beiden Dioden D1, D2 miteinander elektrisch verbindet, an einem Anschlusspunkt AP1 des Messpfades MP elektrisch angeschlossen, der die beiden Widerstände R31, R32 miteinander elektrisch verbindet.

Die Schutzschaltungseinheit SE ist eingerichtet, den Signalwert des an dem negativen Anschluss NA gemessenen Messsignals zwischen einem an dem dritten Stromanschluss SA3 angelegten Spannungspotential und dem Massepotential zu beschränken und somit eine nachfolgend zu beschreibende Ermittlungsanordnung EA vor einer Überlastung durch Überspannungen zu schützen.

Die Schaltungsvorrichtung SV umfasst außerdem die zuvor erwähnte Ermittlungsanordnung EA, die über einen Signaleingang SG mit einem Anschlusspunkt AP2 des Messpfades MP mit der Messanordnung MA signaltechnisch verbunden ist, wobei der Anschlusspunkt AP2 den zweiten Widerstand R32 und den Kondensator C der Messanordnung MA miteinander elektrisch verbindet und zugleich einen Signalausgang der Messanordnung MA ausbildet.

Die Ermittlungsanordnung EA umfasst einen Komparator KP (also eine Vergleichseinheit), der die von der Messanordnung MA weitergeleiteten Messwerte direkt mit vorgegebenen Referenzwerten vergleicht. Alternativ oder zusätzlich umfasst die Ermittlungsanordnung EA einen Analog-Digital-Wandler, der eingerichtet ist, die von der Messanordnung MA gemessen und der Ermittlungsanordnung EA übermittelte analoge Messwerte in digitale Messwerte umzuwandeln, die dann von der Ermittlungsanordnung EA mit vorab ermittelt und als digitale Größen gespeicherten Referenzwerten verglichen werden.

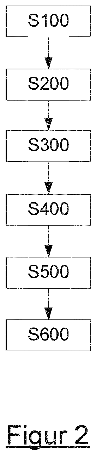

Nachfolgend wird die Funktionsweise der zuvor beschriebenen Berührungsschutzschaltung BS anhand Figur 2 und in Verbindung mit verschieden Zuständen bei den zu überwachenden Hochvoltkomponenten HK sowie bei der Verriegelungsleiterschleife VS beschrieben.

Die Berührungsschutzschaltung BS überwacht mittels der Verriegelungsleiterschleife VS insb. mittels dem bzw. den Schaltern ST in der Verriegelungsleiterschleife VS die Zustände der Gehäuse und der sonstigen Isoliermaßnahmen der Hochvoltkomponenten HK. Dabei werden insb. folgende Zustände ermittelt bzw. erkannt:
Zustand 1: Solange die Gehäuse der Hochvoltkomponenten HK fehlerfrei geschlossen sind und die Isoliermaßnahmen der Hochvoltkomponenten HK fehlerfrei funktionieren, und somit die Hochvoltkomponenten HK von der Umgebung sicher elektrisch isoliert sind, werden die Schalter ST in der Verriegelungsleiterschleife VS in einer dem Fachmann bekannten Weise (vergleiche die Druckschrift WO 2009/112165) geschlossen gehalten. In diesen fehlerfreien Zuständen sind der erste und der zweite Leitungsende LE1, LE2 der Verriegelungsleiterschleife VS über die geschlossenen Schalter ST miteinander elektrisch kurzgeschlossen.
Zustand 2: Sobald ein oder mehrere Gehäuse bzw. eine oder mehrere Isoliermaßnahmen der Hochvoltkomponenten HK durch beispielweise eine mechanische Einwirkung beschädigt oder unbeabsichtigt geöffnet bzw. deaktiviert, so werden ein oder mehrere Schalter ST in einer dem Fachmann bekannten Weise (vergleiche die Druckschrift WO 2009/112165) geöffnet. Folglich wird die Verriegelungsleiterschleife VS unterbrochen und die beiden Leitungsende LE1, LE2 der Verriegelungsleiterschleife VS werden voneinander elektrisch getrennt.
Zustand 3: Durch einen fehlerhaften Anschluss oder sonstige Fehler kann die Verriegelungsleiterschleife VS, die an sich geschlossen ist (d. h. nicht elektrisch getrennt ist), an dem ersten Stromanschluss SA1 und somit an der externen Spannungsquelle elektrisch kurzgeschlossen werden.
Zustand 4: Analog kann die Verriegelungsleiterschleife VS, die an sich geschlossen ist (und somit nicht elektrisch getrennt ist), durch einen fehlerhaften Anschluss oder sonstige Fehler an dem Masseanschluss ML und somit an der elektrischen Masse MS elektrisch kurzgeschlossen werden.
Weitere Zustände: Es gibt auch weitere Zustände der Verriegelungsleiterschleife VS, die keinem bestimmten Fehlverhalten der Verriegelungsleiterschleife VS eindeutig zugeordnet werden können. Diese Zustände unterscheiden sich jedoch eindeutig von den zuvor genannten Zuständen 1 bis 4.

Die zuvor genannten Zustände der Verriegelungsleiterschleife VS werden von der Schaltungsvorrichtung SV in nachfolgend zu beschreibender Weise erkannt:
Um zu überprüfen, welcher der oben genannten Zustände vorliegt, wird in einem ersten Messvorgang gemäß einem Verfahrensschritt S100 über den Signalanschluss SS dem Gateanschluss des MOSFETs MT der Stromquelle SQ ein erstes Steuersignal mit einem Signalpegel von "Logisch Null" (in der Regel mit einer Signalspannung von 0 Volt) angelegt. Als Folge wird der MOSFET MT geöffnet und der referenzstrompfadseitige Bipolartransistor BT1 wird geschlossen. Dadurch wird die Stromquelle SQ aktiv und generiert einen kontanten Gleichstrom I1, der durch den Laststrompfad LD und somit von dem ersten Stromanschluss SA1 über den Laststrompfad LD zu dem Masseanschluss ML fließt.

Liegt der oben genannte Zustand 1 vor (die Gehäuse und sonstige Isoliermaßnahmen der Hochvoltkomponente HK sind fehlerfrei) und somit alle Schalter ST in der Verriegelungsleiterschleife VS geschlossen, so fließt der von der Stromquelle SQ generierte Gleichstrom I1 von der Strombegrenzungsschaltung SB aufgeteilt und zum Teil durch die Widerstände R12, R13 der Strombegrenzungsschaltung SB zu der Verriegelungsleiterschleife VS und zum Teil direkt zu dem Überbrückungswiderstand Rb.

Die an dem ersten Stromanschluss SA1 anliegende Betriebsspannung Vss fällt dann an den Widerständen R11, R12, R13 und dem Überbrückungswiderstand Rb sowie dem Widerstand R22 ab. An dem negativen Anschluss NA kann somit ein Spannungspotential Φ (bzw. die Spannung zwischen dem negativen Anschluss NA und dem Masseanschluss ML) gemessen werden, dessen Wert kleiner als der Wert der Betriebsspannung Vss ist aber diesem Wert nah liegt (aufgrund der Dreifach-Parallelschaltung der drei Widerstände R12, R13 und Rb infolge der geschlossenen Verriegelungsleiterschleife VS).

Liegt der oben genannte Zustand 2 vor (eins der Gehäuse geöffnet oder eine der sonstigen Isoliermaßnahmen fehlerhaft) und somit sind die entsprechenden Schalter ST geöffnet und folglich ist auch die Verriegelungsleiterschleife VS unterbrochen, so fließt der von der Stromquelle SQ generierte Gleichstrom I1 von dem ersten Stromanschluss SA1 ausschließlich über den Überbrückungswiderstand Rb zu dem Masseanschluss ML.

Durch die Unterbrechung der Verriegelungsleiterschleife VS fließt durch den parallelen Strompfad SD2 über die beiden Widerstände R12, R13 kein Strom. Dadurch wird der gesamte elektrische Widerstand zwischen dem ersten Stromanschluss SA1 und dem negativen Anschluss NA etwas größer sein als der gesamte Widerstand der Dreifach-Parallelschaltung bei dem Zustand 1. Folglich kann an dem negativen Anschluss NA ein Spannungspotential Φ gemessen werden, dessen Wert unter dem Wert der Betriebsspannung Vss und auch unter dem Wert des beim Zustand 1 gemessenen Spannungspotentials Φ liegt.

Liegt der oben genannte Zustand 3 vor (die Verriegelungsleiterschleife VS an dem Stromanschluss SA1 elektrisch kurzgeschlossen) und somit ist der negative Anschluss NA an dem Stromanschluss SA1 elektrisch kurzgeschlossen, so wird an dem negativen Anschluss NA ein Spannungspotential Φ gemessen, dessen Wert dem Wert der Betriebsspannung Vss nah liegt.

Liegt der oben genannte Zustand 4 vor (die Verriegelungsleiterschleife VS an dem Masseanschluss ML elektrisch kurzgeschlossen) und somit ist der negative Anschluss NA an dem Masseanschluss ML elektrisch kurzgeschlossen, so wird an dem negativen Anschluss NA ein Spannungspotential Φ gemessen, dessen Wert dem Wert des Massepotentials nah liegt.

Das Spannungspotential Φ an dem negativen Anschluss NA wird gemäß einem weiteren Verfahrensschritt S200 von der Messanordnung MA gemessen und als ein erster Potentialmesswert Φ1 der Ermittlungsanordnung EA weitergeleitet.

Der erste Potentialmesswert Φ1 wird anschließend von der Ermittlungsanordnung EA gemäß einem weiteren Verfahrensschritt S300 mit einem ersten und einem zweiten vorgegebenen Potentialreferenzwert Ur1, Ur2 verglichen, wobei gilt: Ur1<Ur2.

Ferner wird in einem zweiten Messvorgang gemäß einem weiteren Verfahrensschritt S400 über den Signalanschluss SS dem Gateanschluss des MOSFETs MT ein zweites Steuersignal mit einem Signalpegel von "Logisch Eins" (in der Regel mit einer Spannung von 5 Volt) angelegt. Als Folge wird der MOSFET MT geschlossen und die beiden Bipolartransistoren BT1, BT2 werden geöffnet. Dadurch wird die Stromquelle SQ inaktiv. Folglich fließt kein Strom bzw. ein Strom I2 mit einer Stromstäke von 0 Ampere dem ersten Stromanschluss SA1 über den Laststrompfad LD zu dem Masseanschluss ML.

Liegt einer der Zustände 1, 2 oder 3 vor, so wird an dem negativen Anschluss NA ein Spannungspotential Φ gemessen, dessen Wert (als ein zweiter Potentialmesswert Φ2) dem Wert der Betriebsspannung Vss nah liegt.

Liegt der oben genannte Zustand 4 vor, so wird an dem negativen Anschluss NA ein Spannungspotential gemessen, dessen Wert dem Wert des Massepotentials nah liegt.

Das Spannungspotential Φ an dem negativen Anschluss NA wird gemäß einem weiteren Verfahrensschritt S500 von der Messanordnung MA gemessen und als ein zweiter Potentialmesswert Φ2 der Ermittlungsanordnung EA weitergeleitet.

Der zweite Potentialmesswert Φ2 dann anschließend von der Ermittlungsanordnung EA gemäß einem weiteren Verfahrensschritt S600 mit einem dritten und einem vierten vorgegebenen Potentialreferenzwert Ur3, Ur4 verglichen, wobei gilt: Ur3<Ur4.

Liegt der erste Potentialmesswert Φ1 zwischen dem ersten und dem zweiten Potentialreferenzwert Ur1 und Ur2 und zugleich ist der zweite Potentialmesswert Φ2 größer als der vierte Potentialreferenzwert Ur4 (also wenn eine folgende logische Verknüpfung erfüllt ist: Ur1<Φ1<Ur2 & Ur4<Φ2), so wird erkannt, dass der Zustand 1 vorliegt und die Verriegelungsleiterschleife VS fehlerfrei geschlossen ist.

Ist der erste Potentialmesswert Φ1 kleiner als der erste Potentialreferenzwert Ur1 und zugleich ist der zweite Potentialmesswert Φ2 größer als der vierte Potentialreferenzwert Ur4 (also wenn eine folgende logische Verknüpfung erfüllt ist: Φ1<Ur1 & Ur4<Φ2), so wird erkannt, dass der Zustand 2 vorliegt und einer der Schalter ST geöffnet ist und somit die Verriegelungsleiterschleife VS elektrisch unterbrochen ist.

Ist der erste Potentialmesswert Φ1 größer als der zweite Potentialreferenzwert Ur2 und zugleich ist der zweite Potentialmesswert Φ2 größer als der vierte Potentialreferenzwert Ur4 (also eine folgende logische Verknüpfung erfüllt ist:Ur2<Φ1 & Ur4<Φ2), so wird erkannt, dass der Zustand 3 vorliegt und die Verriegelungsleiterschleife VS zu dem ersten Stromanschluss SA1 bzw. der Spanungsquelle elektrisch kurzgeschlossen ist.

Ist der erste Potentialmesswert Φ1 kleiner als der erste Potentialreferenzwert Ur1 und zugleich ist der zweite Potentialmesswert Φ2 kleiner als der dritte Potentialreferenzwert Ur3 (also wenn eine folgende logische Verknüpfung erfüllt ist: Φ1<Ur1 & Φ2<Ur3), so wird erkannt, dass der Zustand 4 vorliegt und die Verriegelungsleiterschleife VS zu dem Masseanschluss ML bzw. der elektrischen Masse MS elektrisch kurzgeschlossen ist.

Liegt zwischen den beiden Potentialmesswerten Φ1, Φ2 und den vier Potentialreferenzwerten Ur1, Ur2, Ur3 und ur4 eine von den oben beschriebenen Verknüpfungen abweichende logische Verknüpfung vor, so wird erkannt, dass einer der zuvor genannten weiteren nicht eindeutig zuordenbaren Zustände vorliegt.

Wird der fehlerhafte Zustand 2 erkannt, so gibt die Ermittlungsanordnung EA durch Abgabe eines Signals an einer in der Figur nicht dargestellten zentralen Steuervorrichtung des Elektrofahrzeugs ab und veranlasst diese, die Hochvoltkomponenten HK beispielsweise durch Entladen oder durch elektrisches Trennen von dem Bordnetz des Elektrofahrzeugs zu deaktivieren.

Wird der fehlerhafte Zustand 3 oder 4 erkannt, so gibt die Ermittlungsanordnung EA beispielsweise durch Abgabe eines weiteren Signals an einer in der Figur nicht dargestellten Fahrzeugsignalanzeigevorrichtung und macht den Fahrer des Elektrofahrzeugs auf den fehlerhaften Zustand aufmerksam, so dass dieser das Elektrofahrzeug zur Reparatur der Berührungsschutzschaltung BS in eine Fahrzeugwerkstatt bringt.

## Patentansprüche

1. Schaltungsvorrichtung (SV) zum Ermitteln eines Zustandes einer elektrischen Verriegelungsleiterschleife (VS) zur Überwachung zumindest einer Hochvoltkomponente (HK), umfassend:
- einen Stromanschluss (SA1) zur elektrischen Verbindung zu einer Spannungsquelle;
- einen Masseanschluss (ML) zur elektrischen Verbindung zu einer elektrischen Masse (MS);
- einen positiven Anschluss (PA) zur elektrischen Verbindung mit einem Leitungsende (LE1) der Verriegelungsleiterschleife (VS);
- einen negativen Anschluss (NA) zur elektrischen Verbindung mit einem weiteren Leitungsende (LE2) der Verriegelungsleiterschleife (VS),
**dadurch gekennzeichnet, dass**
die Schaltungsvorrichtung (SV) ferner umfasst:
- eine steuerbare Stromquelle (SQ) zum Bereitstellen der beiden Ströme (I1, 12) umfasst, die zwischen dem negativen Anschluss (NA) und dem Masseanschluss (ML) elektrisch angeschlossen ist;
- eine Messanordnung (MA) zum Messen des Spannungspotentials (Φ) an dem negativen Anschluss (NA) bei zwei von dem Stromanschluss (SA1) über den negativen Anschluss (NA) zu dem Masseanschluss (ML) fließenden, voneinander unterschiedlichen Strömen (11, 12); und
- eine Ermittlungsanordnung (EA), die eine Vergleichseinheit (KP) zum Vergleichen der zwei bei den beiden Strömen (11, 12) gemessenen Potentialmesswerte (Φ1, Φ2) des Spannungspotentials (Φ) jeweils mit zwei vorgegebenen Potentialreferenzwerten (Ur1, Ur2 bzw. Ur3, Ur4) umfasst und eingerichtet ist, basierend auf den Vergleichsergebnissen der Vergleichseinheit (KP) zu erkennen, ob der negative Anschluss (NA) mit dem positiven Anschluss (PA), dem Stromanschluss (SA1) oder dem Masseanschluss (ML), oder mit keinem von diesen Anschlüssen (PA, SA1, ML) elektrisch kurzgeschlossen ist ;
wobei ein fehlerfreier Zustand der Verriegelungsleiterschleife (VS) erkannt wird, falls der erste Potentialmesswert (Φ1) zwischen dem ersten (Url) und dem zweiten (Ur2) Potentialreferenzwert liegt und der zweite Potentialmesswert (Φ2) größer als der vierte Potentialreferenzwert (Ur4) ist.

2. Schaltungsvorrichtung (SV) nach Anspruch 1, wobei die Stromquelle (SQ) als eine Konstantstromquelle oder als eine skalierbare bzw. modulierbare Stromquelle ausgebildet ist.

3. Schaltungsvorrichtung (SV) nach Anspruch 1 oder 2, wobei die Stromquelle (SQ) eine Stromspiegelschaltung (SP) umfasst.

4. Berührungsschutzschaltung (BS) zur Überwachung zumindest einer Hochvoltkomponente (HK), umfassend:
- eine elektrische Verriegelungsleiterschleife (VS) zur Überwachung der zumindest einen Hochvoltkomponente (HK),
**dadurch gekennzeichnet, dass**
die Berührungsschutzschaltung (BS) ferner umfasst:
- eine Schaltungsvorrichtung (SV) nach einem der vorangehenden Ansprüche zum Ermitteln des Zustandes der Verriegelungsleiterschleife (VS),
- wobei die Schaltungsvorrichtung (SV) über den positiven Anschluss (PA) mit einem Leitungsende (LE1) der Verriegelungsleiterschleife (VS) und über den negativen Anschluss (NA) mit einem weiteren Leitungsende (LE2) der Verriegelungsleiterschleife (VS) elektrisch verbunden ist.

5. Fahrzeug, insb. Hybridelektro- oder Elektrofahrzeug, umfassend:
- zumindest eine Hochvoltkomponente (HK),
- zumindest eine Berührungsschutzschaltung (BS) Anspruch 4 zur Überwachung der zumindest einen Hochvoltkomponente (HK).

6. Verfahren zum Ermitteln eines Zustandes einer elektrischen Verriegelungsleiterschleife (VS) zur Überwachung zumindest einer Hochvoltkomponente (HK) mit einer Schaltungsvorrichtung (SV) nach einem der Ansprüche 1 bis 3, umfassend folgende Schritte:
- Generieren (S100) eines ersten Stromes (I1), der von dem Stromanschluss (SA1) über den negativen Anschluss (NA) zu dem Masseanschluss (ML) fließt;
- Messen (S200) des Spannungspotentials (Φ) an dem negativen Anschluss (NA), während der erste Strom (I1) fließt;
- Vergleichen (S300) eines ersten gemessenen Potentialmesswertes (Φ1) mit einem ersten (Ur1) und einem zweiten (Ur2) Potentialreferenzwert, wobei gilt Ur1<Ur2;
- Generieren (S400) eines zweiten Stromes (12), der von dem Stromanschluss (SA1) über den negativen Anschluss (NA) zu dem Masseanschluss (ML) fließt;
- Messen (S500) des Spannungspotentials (Φ) an dem negativen Anschluss (NA), während der zweite Strom (I2) fließt;
- Vergleichen (S600) des gemessenen zweiten Potentialmesswertes (Φ2) mit einem dritten (Ur3) und einem vierten (Ur4) Potentialreferenzwert, wobei gilt Ur3<Ur4;
- wobei ein fehlerfreier Zustand der Verriegelungsleiterschleife (VS) erkannt wird, falls der erste Potentialmesswert (Φ1) zwischen dem ersten (Ur1) und dem zweiten (Ur2) Potentialreferenzwert liegt und der zweite Potentialmesswert (Φ2) größer als der vierte Potentialreferenzwert (Ur4) ist.

7. Verfahren nach Anspruch 6, wobei eine elektrische Unterbrechung der Verriegelungsleiterschleife (VS) erkannt wird, falls der erste Potentialmesswert (Φ1) kleiner als der erste Potentialreferenzwert (Ur1) ist und der zweite Potentialmesswert (Φ2) größer als der vierte Potentialreferenzwert (Ur4) ist.

8. Verfahren nach Anspruch 6 oder 7, wobei ein elektrischer Kurzschluss der Verriegelungsleiterschleife (VS) zu dem Stromanschluss (SA1) erkannt wird, falls der erste Potentialmesswert (Φ1) größer als der zweite Potentialreferenzwert (Ur2) ist und der zweite Potentialmesswert (Φ2) größer als der vierte Potentialreferenzwert (Ur4) ist.

9. Verfahren nach einem der Ansprüche 6 bis 8, wobei ein elektrischer Kurzschluss der Verriegelungsleiterschleife (VS) zu dem Masseanschluss (ML) erkannt wird, falls der erste Potentialmesswert (Φ1) kleiner als der erste Potentialreferenzwert (Ur1) ist und der zweite Potentialmesswert (Φ2) kleiner als der dritte Potentialreferenzwert (Ur3) ist.

## Claims

1. Circuit apparatus (SV) for detecting a state of an electrical interlock loop (VS) for monitoring at least one high-voltage component (HK), comprising:
- a power connection (SA1) for electrical connection to a voltage source;
- a ground connection (ML) for electrical connection to an electrical ground (MS);
- a positive connection (PA) for electrical connection to a line end (LE1) of the interlock loop (VS);
- a negative connection (NA) for electrical connection to a further line end (LE2) of the interlock loop (VS),
**characterized in that** the circuit apparatus (SV) furthermore comprises:
- a controllable current source (SQ) for providing the two currents (I1, 12), said current source being electrically connected between the negative connection (NA) and the ground connection (ML);
- a measuring arrangement (MA) for measuring the voltage potential (**Φ**) at the negative connection (NA) when two mutually different currents (I1, 12) flow from the power connection (SA1) via the negative connection (NA) to the ground connection (ML); and
- a detector arrangement (EA), which comprises a comparison unit (KP) for comparing the two potential measurement values (**Φ**1, **Φ**2) of the voltage potential (**Φ**) that are measured at the two currents (I1, 12) with in each case two predefined potential reference values (Ur1, Ur2 and Ur3, Ur4, respectively) and which is configured to ascertain, based on the comparison results of the comparison unit (KP), whether the negative connection (NA) is electrically short-circuited with the positive connection (PA), the power connection (SA1) or the ground connection (ML), or with none of these connections (PA, SA1, ML);
wherein a fault-free state of the interlock loop (VS) is ascertained if the first potential measurement value (**Φ**1) lies between the first (Ur1) and the second (Ur2) potential reference value and the second potential measurement value (**Φ**2) is greater than the fourth potential reference value (Ur4) .

2. Circuit apparatus (SV) according to Claim 1, wherein the current source (SQ) is embodied as a constant current source or as a scalable or modulatable current source.

3. Circuit apparatus (SV) according to Claim 1 or 2, wherein the current source (SQ) comprises a current mirror circuit (SP) .

4. Contact protection circuit (BS) for monitoring at least one high-voltage component (HK), comprising:
- an electrical interlock loop (VS) for monitoring the at least one high-voltage component (HK),
**characterized in that**
the contact protection circuit (BS) furthermore comprises:
- a circuit apparatus (SV) according to one of the preceding claims for detecting the state of the interlock loop (VS),
- wherein the circuit apparatus (SV) is electrically connected to a line end (LE1) of the interlock loop (VS) via the positive connection (PA) and to a further line end (LE2) of the interlock loop (VS) via the negative connection (NA).

5. Vehicle, in particular hybrid electric or electric vehicle, comprising:
- at least one high-voltage component (HK),
- at least one contact protection circuit (BS) according to Claim 4 for monitoring the at least one high-voltage component (HK).

6. Method for detecting a state of an electrical interlock loop (VS) for monitoring at least one high-voltage component (HK) with a circuit apparatus (SV) according to one of Claims 1 to 3, comprising the following steps:
- generating (S100) a first current (I1), which flows from the power connection (SA1) via the negative connection (NA) to the ground connection (ML);
- measuring (S200) the voltage potential (**Φ**) at the negative connection (NA), while the first current (I1) is flowing;
- comparing (S300) a first measured potential measurement value (**Φ**1) with a first (Ur1) and a second (Ur2) potential reference value, wherein Ur1<Ur2 holds true;
- generating (S400) a second current (12), which flows from the power connection (SA1) via the negative connection (NA) to the ground connection (ML);
- measuring (S500) the voltage potential (**Φ**) at the negative connection (NA), while the second current (I2) is flowing;
- comparing (S600) the measured second potential measurement value (**Φ**2) with a third (Ur3) and a fourth (Ur4) potential reference value, wherein Ur3<Ur4 holds true;
- wherein a fault-free state of the interlock loop (VS) is ascertained if the first potential measurement value (**Φ**1) lies between the first (Ur1) and the second (Ur2) potential reference value and the second potential measurement value (**Φ**2) is greater than the fourth potential reference value (Ur4).

7. Method according to Claim 6, wherein an electrical interruption of the interlock loop (VS) is ascertained if the first potential measurement value (**Φ**1) is smaller than the first potential reference value (Ur1) and the second potential measurement value (**Φ**2) is greater than the fourth potential reference value (Ur4).

8. Method according to Claim 6 or 7, wherein an electrical short circuit of the interlock loop (VS) to the power connection (SA1) is ascertained if the first potential measurement value (**Φ**1) is greater than the second potential reference value (Ur2) and the second potential measurement value (**Φ**2) is greater than the fourth potential reference value (Ur4).

9. Method according to one of Claims 6 to 8, wherein an electrical short circuit of the interlock loop (VS) to the ground connection (ML) is ascertained if the first potential measurement value (**Φ**1) is smaller than the first potential reference value (Ur1) and the second potential measurement value (**Φ**2) is smaller than the third potential reference value (Ur3).

## Revendications

1. Dispositif de circuit (SV) destiné à déterminer un état d'une boucle conductrice de verrouillage (VS) électrique servant à surveiller au moins un composant haute tension (HK), comprenant :
- une borne de courant (SA1) servant à la connexion électrique avec une source de tension ;
- une borne de masse (ML) servant à la connexion électrique avec une masse électrique (MS) ;
- une borne positive (PA) servant à la connexion électrique avec une extrémité de ligne (LE1) de la boucle conductrice de verrouillage (VS) ;
- une borne négative (NA) servant à la connexion électrique avec une autre extrémité de ligne (LE2) de la boucle conductrice de verrouillage (VS),
**caractérisé en ce que**
le dispositif de circuit (SV) comporte en plus :
- une source de courant (SQ) commandable destinée à fournir les deux courants (I1, I2), qui est raccordée électriquement entre la borne négative (NA) et la borne de masse (ML) ;
- un arrangement de mesure (MA) destiné à mesurer le potentiel de tension (**Φ**) à la borne négative (NA) dans le cas de deux courants (I1, I2) différents l'un de l'autre qui circulent de la borne de courant (SA1) vers la borne de masse (ML) par le biais de la borne négative (NA) ; et
- un arrangement de détermination (EA), qui comporte une unité de comparaison (KP) destinée à comparer les deux valeurs mesurées de potentiel (**Φ**1, **Φ**2) du potentiel de tension (**Φ**) mesurées dans le cas des deux courants (I1, I2) respectivement avec deux valeurs de référence de potentiel (Ur1, Ur2 ou Ur3, Ur4) prédéfinies et qui est conçu pour, en se basant sur les résultats de comparaison de l'unité de comparaison (KP), reconnaître si la borne négative (NA) est en court-circuit électrique avec la borne positive (PA), la borne de courant (SA1) ou la borne de masse (ML), ou avec aucune de ces bornes (PA, SA1, ML) ;
un état exempt de défaut de la boucle conductrice de verrouillage (VS) étant reconnu dans le cas où la première valeur mesurée de potentiel (**Φ**1) est comprise entre la première (Ur1) et la deuxième (Ur2) valeur de référence de potentiel et la deuxième valeur mesurée de potentiel (**Φ**2) est supérieure à la quatrième valeur de référence de potentiel (Ur4) .

2. Dispositif de circuit (SV) selon la revendication 1, la source de courant (SQ) étant réalisée sous la forme d'une source de courant constant ou sous la forme d'une source de courant évolutif ou modulable.

3. Dispositif de circuit (SV) selon la revendication 1 ou 2, la source de courant (SQ) comprenant un circuit miroir de courant (SP).

4. Circuit de protection contre le toucher (BS) destiné à surveiller au moins un composant haute tension (HK), comprenant :
- une boucle conductrice de verrouillage (VS) électrique servant à surveiller l'au moins un composant haute tension (HK),
**caractérisé en ce que**
le circuit de protection contre le toucher (BS) comprend en outre :
- un dispositif de circuit (SV) selon l'une des revendications précédentes destiné à déterminer l'état de la boucle conductrice de verrouillage (VS),
- le dispositif de circuit (SV) étant relié électriquement à une extrémité de ligne (LE1) de la boucle conductrice de verrouillage (VS) par le biais de la borne positive (PA) et à une autre extrémité de ligne (LE2) de la boucle conductrice de verrouillage (VS) par le biais de la borne négative (NA).

5. Véhicule, notamment véhicule électrique hybride ou électrique, comprenant :
- au moins un composant haute tension (HK),
- au moins un circuit de protection contre le toucher (BS) selon la revendication 4 destiné à surveiller l'au moins un composant haute tension (HK).

6. Procédé pour déterminer un état d'une boucle conductrice de verrouillage (VS) électrique servant à surveiller au moins un composant haute tension (HK) avec un dispositif de circuit (SV) selon l'une des revendications 1 à 3, comprenant les étapes suivantes :
- génération (S100) d'un premier courant (I1) qui circule de la borne de courant (SA1) vers la borne de masse (ML) par le biais de la borne négative (NA) ;
- mesure (S200) du potentiel de tension (**Φ**) à la borne négative (NA) pendant que le premier courant (I1) circule ;
- comparaison (S300) d'une première valeur mesurée de potentiel (**Φ**1) mesurée avec une première (Ur1) et une deuxième (Ur2) valeur de référence de potentiel, avec Ur1 < Ur2 ;
- génération (S400) d'un deuxième courant (I2) qui circule de la borne de courant (SA1) vers la borne de masse (ML) par le biais de la borne négative (NA) ;
- mesure (S500) du potentiel de tension (**Φ**) à la borne négative (NA) pendant que le deuxième courant (I2) circule ;
- comparaison (S600) de la deuxième valeur mesurée de potentiel (**Φ**2) mesurée avec une troisième (Ur3) et une quatrième (Ur4) valeur de référence de potentiel, avec Ur3 < Ur4 ;
un état exempt de défaut de la boucle conductrice de verrouillage (VS) étant reconnu dans le cas où la première valeur mesurée de potentiel (**Φ**1) est comprise entre la première (Ur1) et la deuxième (Ur2) valeur de référence de potentiel et la deuxième valeur mesurée de potentiel (**Φ**2) est supérieure à la quatrième valeur de référence de potentiel (Ur4).

7. Procédé selon la revendication 6, une interruption électrique de la boucle conductrice de verrouillage (VS) étant reconnue dans le cas où la première valeur mesurée de potentiel (**Φ**1) est inférieure à la première valeur de référence de potentiel (Ur1) et la deuxième valeur mesurée de potentiel (**Φ**2) est supérieure à la quatrième valeur de référence de potentiel (Ur4).

8. Procédé selon la revendication 6 ou 7, un court-circuit électrique de la boucle conductrice de verrouillage (VS) avec la borne de courant (SA1) étant reconnu dans le cas où la première valeur mesurée de potentiel (**Φ**1) est supérieure à la deuxième valeur de référence de potentiel (Ur2) et la deuxième valeur mesurée de potentiel (**Φ**2) est supérieure à la quatrième valeur de référence de potentiel (Ur4).

9. Procédé selon l'une des revendications 6 à 8, un court-circuit électrique de la boucle conductrice de verrouillage (VS) avec la borne de masse (ML) étant reconnu dans le cas où la première valeur mesurée de potentiel (**Φ**1) est inférieure à la première valeur de référence de potentiel (Ur1) et la deuxième valeur mesurée de potentiel (**Φ**2) est inférieure à la troisième valeur de référence de potentiel (Ur3).
